# EUROPÄISCHE PATENTSCHRIFT

(11) **EP 1 937 040 B1**
(45) Veröffentlichungstag und Bekanntmachung des Hinweises auf die Patenterteilung: **23.02.2011**
(21) Anmeldenummer: 07123279.7
(22) Anmeldetag: 14.12.2007
(51) Int. Cl.: H05K 1/02

(54) **Leiterplatte mit einem Hochfrequenzbauelement**
Conductor board with a high frequency component
Plaquette dotée d'un composant haute fréquence

(30) Priorität: 22.12.2006 DE 102006061248
(43) Veröffentlichungstag der Anmeldung: 25.06.2008
(73) Patentinhaber: SIEMENS AKTIENGESELLSCHAFT, 80333 München (DE)
(72) Erfinder: Kornbichler, Andreas, 83623, Dietramszell (DE); Nalezinski, Martin, 81541, München (DE); Richter, Olaf, 13591, Berlin (DE); Ziroff, Andreas Dr., 80469 München (DE)

(56) Entgegenhaltungen:
- EP-A- 1 274 149
- EP-A- 1 594 353
- US-A1- 2003 169 575
- US-A1- 2006 157 832

## Beschreibung

Die vorliegende Erfindung betrifft eine Leiterplatte mit einem Hochfrequenzbauelement gemäß dem Oberbegriff des Patentanspruchs 1.

Aus dem Stand der Technik ist eine solche Leiterplatte mit einer ersten isolierenden Schicht, auf der ein Hochfrequenzbauelement vorgesehen ist, bekannt, wobei eine elektrische Leitung von dem Hochfrequenzbauelement durch die erste Schicht verläuft.

Das Hochfrequenzbauelement ist dabei in einem Gehäusedeckel aufgenommen, der auf der ersten Schicht befestigt ist. Um die notwendige Stabilität zu gewährleisten, ist die erste Schicht dick ausgebildet, d.h. dicker als 1,5 mm, so dass elektrische Hochfrequenzsignale, die von dem Hochfrequenzbauelement durch die erste Schicht hindurchgehen, stark gedämpft werden. Der Deckel besteht entweder aus Kunststoff oder aus Metall.

Wenn der Deckel aus Kunststoff besteht, können jedoch die von dem Hochfrequenzbauelement abgestrahlten elektromagnetischen Wellen durch den Deckel dringen und die Funktion anderer Geräte stören. Umgekehrt können eingestrahlte Wellen die Funktion des Hochfrequenzbauelements stören. Diese Störungen können durch einen Metalldeckel verhindert werden, der entweder für kleine Serien aus Aluminium- oder Messingblöcken gefräst wird oder für große Serien durch Tiefziehen hergestellt wird. Da die Abmessungen des Hohlraums in der Regel größer als eine halbe Wellenlänge der Betriebsfrequenz des Hochfrequenzbauelements sind, werden in Metalldeckeln Hohlraumwellen angeregt. Dadurch wird aber die Funktionsweise des in dem Gehäusedeckel aufgenommenen Hochfrequenzbauelements beeinflusst. Der Metalldeckel muss daher typischerweise in seinem Inneren mit einem Absorbermaterial versehen sein, wodurch Hohlraumwellen unterdrückt werden.

Die US 2006/0157832 A1 offenbart eine gedruckte Schaltungsplatine mit eingebetteten Chips, wobei die Platine eine Hauptschicht mit einem eingebetteten Chip und eine auf einer Oberfläche oder auf beiden Oberflächen der Hauptschicht erzeugte Isolierschicht mit einem Durchgangsloch aufweist, welches mit einer leitenden Tinte gefüllt ist. Des Weiteren weist die gedruckte Schaltungsplatine eine Schaltungsschicht auf, die auf der Isolierschicht ausgebildet ist und ein Durchgangsloch und ein Schaltungsmuster aufweist, das elektrisch zu dem Chip der Hauptschicht durch das Durchgangsloch der Isolierschicht angeschlossen ist. Zusätzlich wird ein Verfahren zur Herstellung einer gedruckten Schaltungsplatine offenbart, die eingebettete Halbleiterchips umfasst.

Die US 2003/0169575 A1 (vergl. den Oberbegriff des Anspruchs 1) offenbart ein Hochfrequenzmodul, in dem eine Ausnehmung zur Befestigung einer Leistungsverstärkervorrichtung auf einer unteren Oberfläche eines dielektrischen Substrates ausgebildet ist. Des Weiteren ist eine Ausnehmung zur Befestigung eines akustischen Oberflächenwellenfilters auf einer oberen Oberfläche des dielektrischen Substrats ausgebildet. Des Weiteren sind eine Leistungsverstärkervorrichtung und ein akustischer Oberflächenwellenfilter jeweils mittels Leiterbumps auf den Ausnehmungen befestigt. Zusätzlich ist ein Durchgangslochleiter zwischen den Ausnehmungen bereitgestellt, wobei ein Ende des Durchgangslochleiters an der unteren Oberfläche des dielektrischen Substrats freigelegt ist. Das freigelegte Ende des Durchgangslochleiters ist mittels eines Lötmaterials an einen Dissipationswärmeleiter angeschlossen.

Der vorliegenden Erfindung liegt die Aufgabe zugrunde, die Qualität von elektrischen Signalen zu verbessern, die von dem Hochfrequenzbauelement durch die erste Schicht hindurchgehen, und gleichzeitig eine ausreichende Stabilität der Leiterplatte zu gewährleisten.

Die der Erfindung zugrunde liegende Aufgabe wird durch eine Leiterplatte mit den Merkmalen des kennzeichnenden Teils des Patentanspruchs 1 gelöst.

Erfindungsgemäß ist die erste Schicht dünn und eine zweite isolierende Schicht zur Verstärkung der ersten Schicht vorgesehen, und ist das Hochfrequenzbauelement in einem Hohlraum in der zweiten Schicht aufgenommen.

In diesem Zusammenhang bedeutet _{"}dünn" weniger als 1,5 mm dick, vorzugsweise weniger als 1 mm dick, noch besser weniger als 0,75 mm dick und noch besser weniger als 0,5 mm dick. Vorteilhafterweise ist ein aufwendiger Metalldeckel nicht erforderlich. Zur Fertigung der zweiten Schicht kann außerdem die kostengünstige Leiterplattenherstellungstechnologie verwendet werden.

In einer bevorzugten Ausführungsform ist auf der zweiten Schicht mindestens ein elektronisches Bauelement angebracht.

Vorteilhafterweise wird durch die zweite Schicht der verfügbare Raum für die Vorsehung von elektronischen Bauelementen vergrößert.

In einer Weiterbildung der bevorzugten Ausführungsform weist die zweite Schicht eine so hohe Temperaturbeständigkeit auf, dass sie in einem Lötprozess bestückbar ist.

Vorteilhafterweise kann die Leiterplatte durch Surface Mount Technology bestückt werden.

In einer bevorzugten Ausführungsform ist auf der Oberseite der zweiten Schicht, die der Unterseite gegenüberliegt, welche mit der ersten Schicht verbunden ist, eine Metallschicht vorgesehen.

Vorteilhafterweise können elektronische Bauteile außerhalb oder auf der zweiten Schicht durch die Metallschicht vor der elektromagnetischen Strahlung abgeschirmt werden, die von dem Hochfrequenzbauelement abgestrahlt wird.

In einer bevorzugten Ausführungsform verlaufen zur ergänzenden Abschirmung des Hochfrequenzbauelements Durchkontaktierungen seitlich zwischen der Oberseite und der Unterseite der zweiten Schicht.

Vorteilhafterweise können elektronische Bauteile außerhalb oder auf der zweiten Schicht durch die Durchkontaktierungen vor der elektromagnetischen Strahlung abgeschirmt werden, die von dem Hochfrequenzbauelement abgestrahlt wird.

In noch einer bevorzugten Ausführungsform ist das Hochfrequenzbauelement ein elektromagnetischer Resonator.

Vorteilhafterweise ist der Hohlraum in der zweiten Schicht in dem sich keine Resonanzen ausbilden können, geeignet für die Aufnahme eines elektromagnetischen Resonators.

In einer Weiterbildung der bevorzugten Ausführungsform ist der elektromagnetische Resonator ein dielektrischer Resonator.

Vorteilhafterweise ist der Hohlraum in der zweiten Schicht in dem sich keine Resonanzen ausbilden können, besonders geeignet für die Aufnahme eines dielektrischen Resonators, der durch die Umgebung besonders stark beeinflusst wird.

In noch einer Weiterbildung der bevorzugten Ausführungsform ist in der Metallschicht auf der Oberseite der metallischen Schicht über dem Hohlraum eine Aussparung ausgebildet, und ist eine metallische Abschirmung auf der Oberseite der zweiten Schicht vorgesehen ist, welche die Aussparung abschirmt.

Vorteilhafterweise kann die Resonanzfrequenz des elektromagnetischen Resonators mit Hilfe der Größe und Position der Aussparung fein justiert werden.

In noch einer bevorzugten Ausführungsform ist zwischen der ersten Schicht und der zweiten Schicht um den Hohlraum herum eine photonische Struktur ausgebildet.

Vorteilhafterweise kann die Ausbreitung von elektromagnetischen Wellen von dem Hohlraum zwischen der ersten Schicht und der zweiten Schicht verhindert werden.

In noch einer bevorzugten Ausführungsform dehnt sich der Hohlraum über eine Fläche aus, die höchstens halb so groß ist wie die Gesamtfläche der zweiten Schicht, und ist die Gesamtfläche der zweiten Schicht mindestens so groß wie die Gesamtfläche der ersten Schicht.

Vorteilhafterweise kann eine besonders feste Verbindung zwischen der ersten Schicht und der zweiten Schicht geschaffen werden und ist auf der zweiten Schicht viel Platz für eine Bestückung mit elektronischen Bauelementen vorhanden.

Im Folgenden wird die Erfindung mit Bezugnahme auf die Zeichnungen näher beschrieben. Es zeigen:
- FIG. 1:: einen Ausschnitt einer Leiterplatte im Schnitt;
- FIG. 2:: einen Ausschnitt einer weiteren Leiterplatte im Schnitt;
- FIG. 3:: eine Ausschnitt einer Leiterplatte mit einem elektromagnetischen Resonanzoszillator im Schnitt;
- FIG. 4:: einen Ausschnitt einer Spannungs/Signaldurchführung, die zwischen einer zweiten Schicht und einer ersten Schicht ausgebildet ist, im Schnitt; und
- FIG. 5:: einen Ausschnitt einer weiteren Spannungs/Signaldurchführung, die zwischen einer zweiten Schicht und einer ersten Schicht ausgebildet ist, im Schnitt.

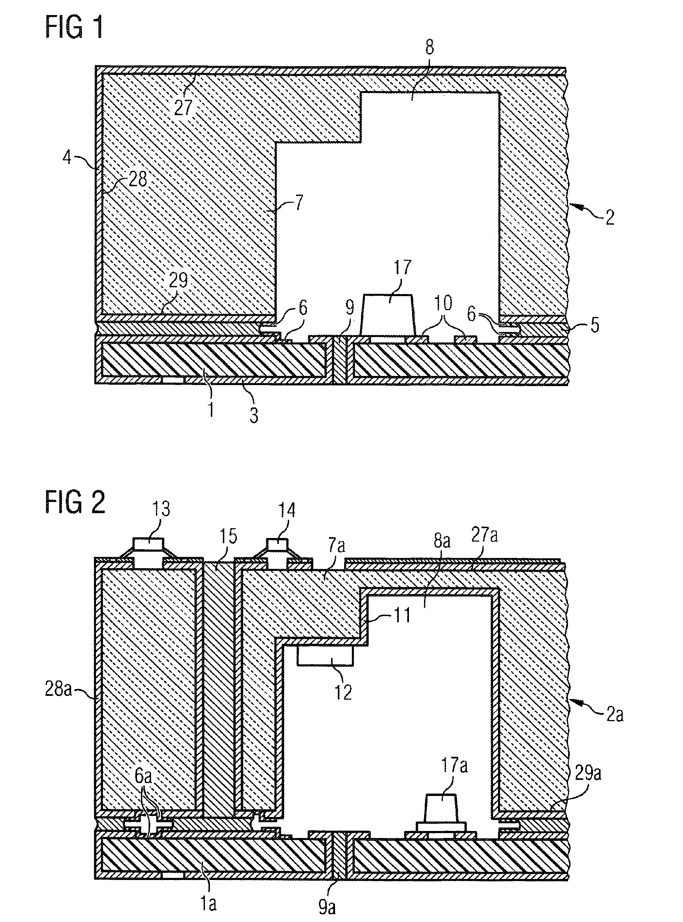

Fig. 1 zeigt eine Leiterplatte mit einer ersten Schicht 1 und einer zweiten Schicht 2, die mit der ersten Schicht 1 verbunden ist. Die erste Schicht 1 und die zweite Schicht 2 sind durch ein Verfahren zur Herstellung von Leiterplatten hergestellt, bestehen als aus einem isolierenden Leiterplattenbasismaterial und können die vollständige Funktionalität einer ersten Schicht aufweisen. Insbesondere die zweite Schicht 2, zu deren Herstellung eine Vielzahl herkömmlicher Werkstoffe und Verfahren verwendbar sind, kann mehrlagig sein. Die erste Schicht 1 und die zweite Schicht 2 weisen jeweils eine Metallkaschierung (Metallschicht) 3 bzw. 4 auf, die vorzugsweise aus Kupfer besteht. Die Metallkaschierungen 3 und 4 verhindern den Austritt von elektromagnetischen Wellen, die von einem Hochfrequenzbauelement 17 im Inneren der zweiten Schicht abgestrahlt werden und können in bestimmten Bereichen durch Ätzen entfernt sein, so dass sie die erste Schicht 1 und den zweite Schicht 2 nicht vollständig bedecken. Es können auch mehrere Hochfrequenzbauelemente, die eine Hochfrequenzschaltung bilden, im Inneren der zweiten Schicht 1 vorgesehen sein. In Fig. 1 ist eine Oberseite 27 der zweiten Schicht 2, eine Seitenfläche 28 der zweiten Schicht 2 und einer Unterseite 29 der zweiten Schicht 2, die um eine Öffnung zu dem Hohlraum 8 verläuft, mit der Metallkaschierung 4 versehen, während die Wände des Hohlraums 8 selbst keine Metallkaschierung aufweist. Eine derartiger zweite Schicht 2 ergibt sich beispielsweise dadurch, dass der Hohlraum 8, der eine beliebige Form haben kann, aus einem isolierenden Basismaterial 7 nach dem Aufbringen der Metallkaschierung 4 gefräst wird. Die Höhe des Hohlraums 8 ist für unterschiedliche Bereiche verschieden, so dass die elektromagnetischen Wellen in dem Hohlraum optimal gedämpft werden.

Die zweite Schicht 2 ist an der Unterseite 29, die den Rand des Hohlraums 8 umgibt, mit Hilfe von Lot 5 auf der ersten Schicht 1 befestigt. Dadurch wird die Öffnung auf der Unterseite der zweiten Schicht 2 verschlossen und der Austritt elektromagnetischer Strahlung aus der Öffnung verhindert. Der Bereich, in dem das Lot 5 vorgesehen ist, ist durch Lötstop-Lack 6 begrenzt. Die zweite Schicht 2 kann auf die erste Schicht 1 auch geklebt statt gelötet werden. Dazu werden Klebpasten oder Klebfolien verwendet. Um dennoch eine gute Abschirmung zu erreichen, sollte der Kleber verlustbehaftet und möglichst dünn aufgetragen sein. Zusätzlich kann die Abschirmung durch Metalle mit photonischer Struktur zwischen der ersten Schicht 1 und der zweiten Schicht 2 verbessert werden. Die Abschirmung durch Lot/Kleber ist nicht immer notwendig. Zur Anbringung der zweiten Schicht 2 auf der erste Schicht 1 können auch beliebige andere Fügeprozesse verwendet werden.

Hochfrequente Wellen, die von dem elektromagnetischen Oszillator abgestrahlt werden, durchdringen die zweite Schicht 2, bevor sie auf die Metallkaschierung 4 auf der Außenseite des zweite Schicht 2 treffen und dort reflektiert werden. Dabei wird ein gewöhnliches Basismaterial, wie es für FR4- oder FR2-Leiterplatten bekannt ist, für die zweite Schicht 2 verwendet, so dass hochfrequente Wellen stark gedämpft werden und Hohlraum-/Gehäuseresonanzen unterdrückt werden.

In dem Hohlraum 8 sind elektrische Leiter 10 ausgebildet, die in der Durchkontaktierung 9 münden, die durch die erste Schicht 1 hindurchgeht. Zur Isolierung der Leiter 10 und auch anderer elektrischer Leiter kann Lötstop-Lack verwendet werden. Die Durchkontaktierung 9, die elektrisch mit dem Hochfrequenzbauelement 17 verbunden ist, leitet ein Signal von dem Hochfrequenzbauelement zu einer Antenne, die in der Metallkaschierung 3 auf der Unterseite der erste Schicht 1 ausgebildet ist. Die erste Schicht 1 ist möglichst dünn (im vorliegenden Fall zumindest dünner als 1,5 mm, noch besser dünner als 1 mm noch besser dünner als 0,75 mm und noch besser dünner als 0,5 mm) ausgebildet, um einen Energieverlust des Signals, der von der Dicke der ersten Schicht 1 abhängt, beim Durchleiten durch die erste Schicht 1 durch Abstrahlung oder dielektrische Verluste zu minimieren und besteht aus einem hochfrequenztauglichen Basismaterial. Durch die zweite Schicht 2, die dicker als 1,5 mm ist, wird die Steifigkeit einer solchen dünnen ersten Schicht 1 erhöht. Indem der Hohlraum 8 genau an die Form des in ihm aufgenommenen Hochfrequenzbauelements 17 bzw. -schaltung angepasst wird, d.h. der Hohlraum eine komplexe Form hat, kann die Stabilität optimiert werden. Der Hohlraum 8 dehnt sich dabei über eine Fläche aus, die höchstens halb so groß wie die Gesamtfläche der zweiten Schicht 2 ist, und die Gesamtfläche der zweiten Schicht 2 ist mindestens so groß wie die Gesamtfläche der ersten Schicht 1.

Für die weiteren Ausführungsformen einer erfindungsgemäßen erste Schicht und eines erfindungsgemäßen zweite Schicht gelten ebenfalls die bezüglich Figur 1 gemachten Angaben, es sei denn, es werden weitere Angaben gemacht, die den bezüglich Figur 1 gemachten Angaben widersprechen. Ähnliche Elemente werden in den folgenden Figuren mit den gleichen Bezugszeichen wie in Figur 1 gefolgt von nachgestellten Buchstaben bezeichnet. Alle dargestellten Merkmale können zudem miteinander kombiniert werden, insofern sie keine Alternativen sind.

FIG. 2 zeigt eine weitere erste Schicht 1a und eine weitere zweite Schicht 2a. Die zweite Schicht 2a unterscheidet sich von der zweiten Schicht 2 zunächst dadurch, dass der zweite Schicht 2a im Hohlraum 8a mit einer Metallkaschierung 11 versehen ist, durch die eine gute Abschirmung erzielt wird. Um Gehäuseresonanzen zu verhindern, ist auf der Metallkaschierung 11 im Inneren des Hohlraums 8a ein Absorber 12 vorgesehen. Außerdem sind auf der zweiten Schicht 2a elektronische Bauelemente 13 und 14 vorgesehen. Die elektronischen Bauelemente 13 und 14 stellen beispielsweise Schaltungen dar, welche für das Hochfrequenzbauelement 17a in dem Hohlraum 8a benötigt werden. Diese Bauelemente 13, 14, wie etwa Spannungsversorgungen oder Signalverstärker mit niedriger Frequenz, erfordern keine Hochfrequenzleiterplatte. Indem Bauelemente 13, 14, die keine Hochfrequenzleiterplatte erfordern, getrennt von anderen Bauelementen auf dem zweite Schicht 2a angebracht werden, können für die zweite Schicht 2a herkömmliche Materialien für eine FR4- oder FR2-Leiterplatte verwendet werden, wodurch sich Herstellungskosten einsparen lassen. Das Basismaterial 7a des zweite Schicht 2a weist noch bei 260°C eine ausreichende Temperaturbeständigkeit auf, so dass die zweite Schicht 2a mit den elektronischen Bauelementen 13 und 14 durch Surface Mounting Technology bestückbar ist.

Bei dem Hohlraum 8a ist eine Durchkontaktierung 15 vorgesehen. Mehrere solche Durchkontaktierungen 15, vorzugsweise im Abstand von weniger als einem Zehntel der Wellenlänge, können einen Zaun bilden, welcher den Hohlraum 8a umgibt und die elektromagnetische Strahlung des elektromagnetischen Oszillators im Hohlraum 8a seitlich ähnlich wie ein Faradayscher Käfig abschirmt. Durchkontaktierungen 15 werden zur Abschirmung verwendet, da es fertigungstechnisch nicht immer möglich ist die Gehäusewände ganz oder teilweise mit einer Metallkaschierung 4a zu versehen. Die zweite Schicht 2a kann außerdem mehrere Lagen aufweisen.

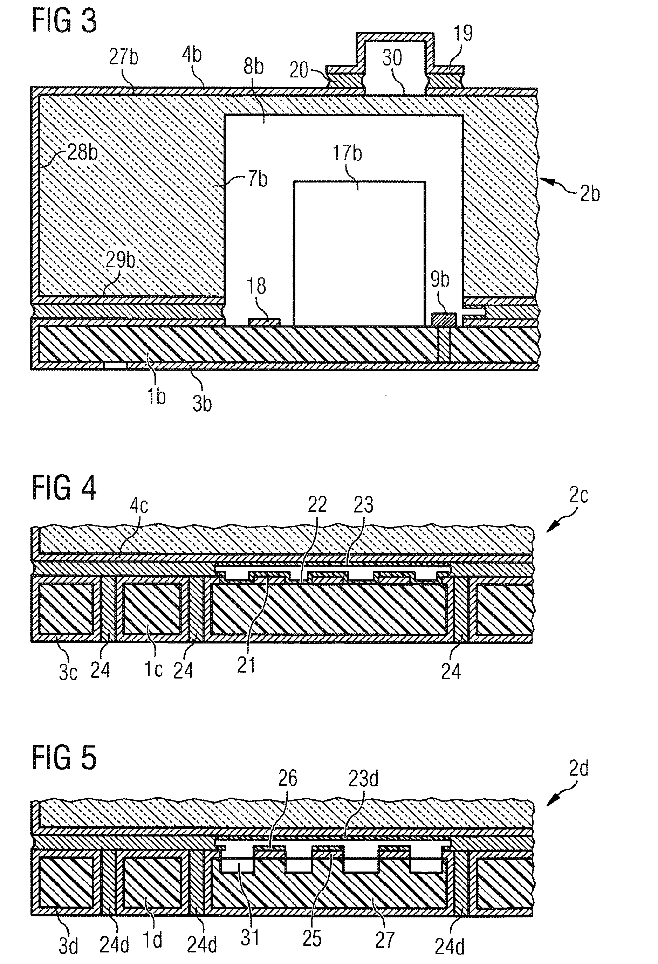

FIG. 3 zeigt eine weitere Leiterplatte mit einer weiteren ersten Schicht 1b, einer weiteren zweite Schicht 2b und einen elektromagnetischen Resonanzoszillator 17b, der in dem Hohlraum 7b auf der ersten Schicht 1b angeordnet ist. Als elektromagnetischer Resonanzoszillator 17b wird vorzugsweise ein dielektrischer Resonator-Oszillator verwendet. Zur Anregung des elektromagnetischen Resonator-Oszillators 17b ist eine elektrische Leitung 18 vorgesehen. Im Hohlraum 8b ist keine Metallkaschierung vorgesehen. Jedoch ist eine Metallkaschierung 4b auf der Oberseite der zweiten Schicht 2b vorgesehen. Eine Durchkontaktierung 9b, die elektrisch mit dem Resonator-Oszillator 17b verbunden ist, leitet ein Signal von dem Resonator-Oszillator zu einer Antenne, die in der Metallkaschierung 3 auf der Unterseite der erste Schicht 1 ausgebildet ist.

Um die Frequenz des elektromagnetischen Resonanzoszillators 17b fein abzustimmen, wird eine Aussparung 30 mit geeigneter Größe in der Metallkaschierung 4b ausgebildet, nachdem die zweite Schicht 2b auf der ersten Schicht 1b befestigt wurde. Daraufhin wird eine Abschirmung 19 über der Aussparung 30 befestigt. Diese hat eine Größe, die ausreichend ist, um jede Aussparung 30 mit einer geeigneten erwarteten Größe abzudecken. Die Größe der Abschirmung 19 muss also nicht speziell an die Aussparung 30 angepasst werden, und die Aussparung 18 muss keinesfalls den gesamten Bereich unter der Abschirmung 30 einnehmen. Alternativ kann der dielektrische Resonator-Oszillator auch durch Vorsehung von elektrischen Leitern in oder an der zweiten Schicht 2b oder in oder an der ersten Schicht 1b abgestimmt werden. Dann lässt sich jedoch nicht die Frequenz des elektromagnetischen Resonanzoszillators 17b abstimmen, nachdem der Hohlraum 8b verschlossen wurde. Eine Abstimmung des Resonanzoszillators kann alternativ auch durch Anbringung eines elektrischen Leiter, z.B. einer Metallfolie oder leitenden Klebers, auf der Außenseite der zweiten Schicht zum Beispiel in der Aussparung 30 unter der Abschirmung 19 erfolgen.

FIG. 4 zeigt eine Spannungs-/ Signaldurchführung, die zwischen einer zweiten Schicht 2c und einer ersten Schicht 1c ausgebildet ist und elektromagnetische Wellen unterdrückt, welche sich zwischen der zweiten Schicht 2c und der ersten Schicht 1c ausbreiten. Die Signaldurchführung besteht aus beabstandeten Leitungen 21 die in einer Ebene zwischen der erste Schicht 1c und dem zweite Schicht 2c ausgebildet sind und die aus der Metallkaschierung 3c ausgeätzt sind, mit der die erste Schicht 1c verkleidet ist. Die Leitungen 21 und auch die Zwischenräume zwischen den Leitungen 21 sind mit einer Schicht 22 aus Lötstop-Lack überzogen, der geeignet ist, hochfrequente elektromagnetische Wellen stark zu dämpfen. Gegenüber den Leitungen 21 auf der Unterseite des zweite Schicht 2c ist ebenfalls eine Schicht 23 aus Lötstop-Lack vorgesehen. Eine derartige Spannungs-/ Signaldurchführung lässt sich durch ein herkömmliches Verfahren zur Herstellung von Leiterplatten erzeugen. In der ersten Schicht sind außerdem Durchkontaktierungen 24 ausgebildet, um eine Wellenausbreitung in der verlustarmen ersten Schicht 1c zu verhindern. Alternativ können die Leitungen 21 auch aus der Metallkaschierung 4c auf dem Rand des zweite Schicht 2c ausgeätzt sein, oder es können sowohl an der erste Schicht 1c als auch an dem Rand des zweite Schicht 2c Leitungen ausgeätzt sein.

FIG. 5 zeigt eine weitere Spannungs-/ Signaldurchführung, die zwischen einer zweiten Schicht 2d und einer erste Schicht 1d ausgebildet ist. Die Spannungs-/ Signaldurchführung besteht aus beabstandeten Leitungen 25, die in einer Ebene zwischen der erste Schicht 1d und dem zweite Schicht 2d ausgebildet sind und die aus der Metallkaschierung 3d ausgeätzt sind, mit der die erste Schicht 1d verkleidet ist. Dabei reichen die ausgeätzten Bereiche bis in ein Basismaterial 27 der erste Schicht 1d. Die Leitungen 25 sind mit einer Schicht 26 aus Lötstop-Lack überzogen. In den ausgeätzten Bereichen ist ein Absorbermaterial 31 vorgesehen.

## Patentansprüche

1. Leiterplatte mit einer ersten isolierenden Schicht (1, 1a, 1b, 1c, 1d), auf der ein Hochfrequenzbauelement (17, 17a, 17b) vorgesehen ist, wobei eine elektrische Leitung (9, 9a, 9b) von dem Hochfrequenzbauelement (17, 17a, 17b) durch die erste Schicht (1, 1a, 1b, 1c, 1d) verläuft, wobei die erste Schicht (1, 1a*,* 1b, 1c, 1d) dünn ist und eine zweite isolierende Schicht (2, 2a, 2b, 2c, 2d) zur Verstärkung der ersten Schicht (1, 1a*,* 1b, 1c, 1d) vorgesehen ist, und dass das Hochfrequenzbauelement (17, 17a, 17b) in einem Hohlraum (8, 8a, 8b) in der zweiten Schicht (2, 2a, 2b, 2c, 2d) aufgenommen ist, wobei auf der Oberseite der zweiten Schicht (2, 2a, 2b, 2c, 2d), die der Unterseite gegenüberliegt, welche mit der ersten Schicht (1, 1a, 1b, 1c, 1d) verbunden ist, eine Metallschicht (4, 4b, 4c) vorgesehen ist, und wobei das Hochfrequenzbauelement (17, 17a, 17b) ein elektromagnetischer Resonator (17b) ist, **dadurch gekennzeichnet, dass** in der Metallschicht (4, 4b, 4c) auf der Oberseite der zweiten Schicht (2, 2a, 2b, 2c, 2d) über dem Hohlraum (8, 8a, 8b) eine Aussparung (30) ausgebildet ist, und dass eine metallische Abschirmung (19) auf der Oberseite der zweiten Schicht (2, 2a, 2b, 2c, 2d) vorgesehen ist, welche die Aussparung (30) abschirmt.

2. Leiterplatte nach Anspruch 1, **dadurch gekennzeichnet, dass** auf der zweiten Schicht (2, 2a, 2b, 2c, 2d) mindestens ein elektronisches Bauelement (13, 14) angebracht ist.

3. Leiterplatte nach Anspruch 2, **dadurch gekennzeichnet, dass** die zweite Schicht (2, 2a, 2b, 2c, 2d) eine so hohe Temperaturbeständigkeit aufweist, dass sie in einem Lötprozess bestückbar ist.

4. Leiterplatte nach Anspruch 1, **dadurch gekennzeichnet, dass** zur ergänzenden Abschirmung des Hochfrequenzbauelements (17, 17a, 17b) Durchkontaktierungen (15) seitlich zwischen der Oberseite und der Unterseite der zweiten Schicht (2, 2a, 2b, 2c, 2d) verlaufen.

5. Leiterplatte nach einem der vorhergehenden Ansprüche, **dadurch gekennzeichnet, dass** der elektromagnetische Resonator (17b) ein dielektrischer Resonator ist.

6. Leiterplatte nach einem der vorhergehenden Ansprüche, **dadurch gekennzeichnet, dass** zwischen der ersten Schicht (1, 1a, 1b, 1c, 1d) und der zweiten Schicht (2, 2a, 2b, 2c, 2d) um den Hohlraum (8, 8a, 8b) herum eine photonische Struktur ausgebildet ist.

7. Leiterplatte nach einem der vorhergehenden Ansprüche, **dadurch gekennzeichnet, dass** sich der Hohlraum über eine Fläche ausdehnt, die höchstens halb so groß ist wie die Gesamtfläche der zweiten Schicht (2, 2a, 2b, 2c, 2d), und dass die Gesamtfläche der zweiten Schicht (2, 2a, 2b, 2c, 2d) mindestens so groß ist wie die Gesamtfläche der ersten Schicht (1, 1a, 1b, 1c, 1d).

## Claims

1. Printed circuit board having a first insulating layer (1, 1a, 1b, 1c, 1d) on which a high-frequency component (17, 17a, 17b) is provided, wherein an electric conductor (9, 9a, 9b) runs from the high-frequency component (17, 17a, 17b) through the first layer (1, 1a, 1b, 1c, 1d), wherein the first layer (1, 1a, 1b, 1c, 1d) is thin and a second insulating layer (2, 2a, 2b, 2c, 2d) is provided for the purpose of reinforcing the first layer (1, 1a, 1b, 1c, 1d), wherein the high-frequency component (17, 17a, 17b) is housed in a cavity (8, 8a, 8b) in the second layer (2, 2a, 2b, 2c, 2d), wherein a metal layer (4, 4b, 4c) is provided on the top side of the second layer (2, 2a, 2b, 2c, 2d) which lies opposite the bottom side which is connected to the first layer (1, 1a, 1b, 1c, 1d), and wherein the high-frequency component (17, 17a, 17b) is an electromagnetic resonator (17b), **characterised in that** a recess (30) is embodied in the metal layer (4, 4b, 4c) on the top side of the second layer (2, 2a, 2b, 2c, 2d) over the cavity (8, 8a, 8b), and **in that** a metallic shield (19) which shields the recess (30) is provided on the top side of the second layer (2, 2a, 2b, 2c, 2d).

2. Printed circuit board according to claim 1, **characterised in that** at least one electronic component (13, 14) is mounted on the second layer (2, 2a, 2b, 2c, 2d).

3. Printed circuit board according to claim 2, **characterised in that** the second layer (2, 2a, 2b, 2c, 2d) has a sufficiently high temperature resistance to allow it to be populated in a solder process.

4. Printed circuit board according to claim 1, **characterised in that** plated-through holes (15) run laterally between the top side and bottom side of the second layer (2, 2a, 2b, 2c, 2d) in order to provide supplementary shielding of the high frequency component (17, 17a, 17b).

5. Printed circuit board according to one of the preceding claims, **characterised in that** the electromagnetic resonator (17b) is a dielectric resonator.

6. Printed circuit board according to one of the preceding claims, **characterised in that** a photonic structure is embodied around the cavity (8, 8a, 8b) between the first layer (1, 1a, 1b, 1c, 1d) and the second layer (2, 2a, 2b, 2c, 2d).

7. Printed circuit board according to one of the preceding claims, **characterised in that** the cavity extends over an area which is at most half as large as the total surface area of the second layer (2, 2a, 2b, 2c, 2d), and **in that** the total surface area of the second layer (2, 2a, 2b, 2c, 2d) is at least as large as the total surface area of the first layer (1, 1a, 1b, 1c, 1d).

## Revendications

1. Plaquette dotée d'une première couche (1, 1a, 1b, 1c, 1d) isolante, sur laquelle est prévu un composant haute fréquence (17, 17a, 17b), une ligne (9, 9a, 9b) électrique partant du composant haute fréquence (17, 17a, 17b) et traversant la première couche (1, 1a, 1b, 1c, 1d), la première couche (1, 1a, 1b, 1c, 1d) étant mince et une seconde couche (2, 2a, 2b, 2c, 2d) isolante étant prévue pour le renforcement de la première couche (1, 1a, 1b, 1c, 1d), et **caractérisée en ce que** le composant haute fréquence (17, 17a, 17b) est réceptionné dans une cavité (8, 8a, 8b) dans la seconde couche (2, 2a, 2b, 2c, 2d), une couche métallique (4, 4b, 4c) étant prévue sur le côté supérieur de la seconde couche (2, 2a, 2b, 2c, 2d), qui fait face au côté inférieur qui est relié à la première couche (1, 1a, 1b, 1c, 1d), et le composant haute fréquence (17, 17a, 17b) étant un résonateur (17b) électromagnétique, **caractérisée en ce qu'**un évidement (30) est formé dans la couche métallique (4, 4b, 4c) sur le côté supérieur de la seconde couche (2, 2a, 2b, 2c, 2d) au-dessus de la cavité (8, 8a, 8b), et **en ce qu'**un blindage (19) métallique est prévu sur le côté supérieur de la seconde couche (2, 2a, 2b, 2c, 2d) qui protège l'évidement (30).

2. Plaquette selon la revendication 1, **caractérisée en ce qu'**au moins un composant (13, 14) électronique est placé sur la seconde couche (2, 2a, 2b, 2c, 2d).

3. Plaquette selon la revendication 2, **caractérisée en ce que** la seconde couche (2, 2a, 2b, 2c, 2d) présente une résistance à la température si élevée qu'elle peut être équipée dans un processus de brasage.

4. Plaquette selon la revendication 1, **caractérisée en ce que**, pour le blindage complémentaire du composant haute fréquence (17, 17a, 17b), des connexions transversales (15) s'étendent sur le côté entre le côté supérieur et le côté inférieur de la seconde couche (2, 2a, 2b, 2c, 2d).

5. Plaquette selon l'une quelconque des revendications précédentes, **caractérisée en ce que** le résonateur (17b) électromagnétique est un résonateur diélectrique.

6. Plaquette selon l'une quelconque des revendications précédentes, **caractérisée en ce qu'**une structure photonique est formée entre la première couche (1, 1a, 1b, 1c, 1d) et la seconde couche (2, 2a, 2b, 2c, 2d) autour de la cavité (8, 8a, 8b).

7. Plaquette selon l'une quelconque des revendications précédentes, **caractérisée en ce que** la cavité s'étend sur une surface qui fait au moins la moitié de la surface totale de la seconde couche (2, 2a, 2b, 2c, 2d), et **en ce que** la surface totale de la seconde couche (2, 2a, 2b, 2c, 2d) est au moins aussi grande que la surface totale de la première couche (1, 1a, 1b, 1c, 1d) .
